(19) **Europäisches Patentamt European Patent Office Office européen des brevets**

(11) **EP 4 664 544 A1**

(12) **EUROPEAN PATENT APPLICATION**
published in accordance with Art. 153(4) EPC

(43) Date of publication:
**17.12.2025 Bulletin 2025/51**

(21) Application number: **23921299.6**

(22) Date of filing: **15.11.2023**

(51) International Patent Classification (IPC):
*H01M 4/133* [(2010.01)]    *H01M 4/134* [(2010.01)]
*H01M 4/1393* [(2010.01)]    *H01M 4/1395* [(2010.01)]
*H01M 4/36* [(2006.01)]    *H01M 4/38* [(2006.01)]
*H01M 4/587* [(2010.01)]

(52) Cooperative Patent Classification (CPC):
H01M 4/133; H01M 4/134; H01M 4/1393;
H01M 4/1395; H01M 4/36; H01M 4/38; H01M 4/587

(86) International application number:
**PCT/JP2023/041033**

(87) International publication number:
**WO 2024/166478 (15.08.2024 Gazette 2024/33)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **07.02.2023 JP 2023017101**

(71) Applicant: **Group14 Technologies, Inc.**
**Woodinville, WA 98072 (US)**

(72) Inventors:
• **KOHNO, Daisuke**
  **Tokyo 105-7325 (JP)**
• **TONEGAWA, Akihisa**
  **Tokyo 105-7325 (JP)**
• **MORI, Takashi**
  **Tokyo 105-7325 (JP)**
• **INOSE, Tsuyoshi**
  **Tokyo 105-7325 (JP)**
• **HARADA, Daisuke**
  **Tokyo 105-7325 (JP)**
• **KONNO, Kaoru**
  **Tokyo 105-7325 (JP)**
• **OGAWA, Hideyuki**
  **Tokyo 105-7325 (JP)**

(74) Representative: **Ostertag & Partner Patentanwälte mbB**
**Azenbergstraße 35**
**70174 Stuttgart (DE)**

(54) **NEGATIVE ELECTRODE FOR LITHIUM-ION BATTERY, METHOD FOR MANUFACTURING NEGATIVE ELECTRODE MATERIAL, AND METHOD FOR IDENTIFYING SAME**

(57) The present invention relates to a negative electrode for a lithium-ion battery, said negative electrode including carbon and silicon, wherein: the negative electrode has a silicon concentration of 2-80 mass% in a negative electrode material layer, and a half-value width of 3.0 deg. or more of a peak in a (111) surface of Si in an XRD pattern in which Cu-K$\alpha$ lines of the negative electrode are used; and, when performing a charging and discharging test under predetermined conditions using a battery in which the negative electrode, a separator, and a positive electrode are stacked, and an electrolyte solution in which a supporting lithium salt is dissolved in a carbonate solvent is used, and the capacity retention of the battery is 95%, in an X-ray photoelectron spectroscopy (XPS) spectrum of the negative electrode surface, the relationship I528(O1s)/I531(O1s)$\geq$0.1 holds, where I528(O1s) is the peak height near a binding energy of 528 eV, and I531(O1s) is the peak height near 531 eV.

EP 4 664 544 A1

## Description

### Technical Field

The present invention relates to a negative electrode for a lithium-ion battery having excellent charging/discharging cycle characteristics and a method for manufacturing a negative electrode material.

### Background Art

Graphite is generally used as a negative electrode material for lithium-ion batteries. The theoretical specific capacity of graphite is 372 mAh/g. The theoretical specific capacity of Si or Sn is higher than that of graphite, and thus when Si or Sn may be used as the negative electrode material, a high capacity lithium-ion battery may be provided. However, particles containing Si or Sn are naturally low in conductivity and have large volumetric changes associated with lithiation and delithiation, causing the particles to break down, disrupt the conductive path, and cause an increase in internal resistance. Therefore, various composite materials composed of Si compounded with a carbon material have been proposed.

For example, patent document 1 proposes a negative electrode active material that contains a silicon-based material composed of $SiO_x$ ($0.5 \leq x \leq 1.6$) and satisfies the relationship between a peak value intensity value A in the Si region given as a chemical shift value of -50 to -95 ppm and a peak value intensity value B in the $SiO_2$ region given as a chemical shift value of -96 to -150 ppm, of $A/B \geq 0.8$ obtained from $^{29}Si$-MAS-NMR spectrum, and discloses negative electrode active material particles including a carbon material in a surface layer portion.

Patent document 2 discloses a negative electrode for a lithium-ion battery including a negative electrode active material including a carbon-based material having a peak at 20 to 30 degrees (002 plane) in an X-ray diffraction pattern using $CuK\alpha$ lines, and further including at least one material selected from an organic substance and an inorganic substance, and including an SEI film having an average thickness of 10 nm to 50 nm on a surface. It is also disclosed that the carbon-based material includes at least one selected from soft carbon and graphite, the organic material includes at least one selected from $ROCO_2Li$ (R is a C1 to C10 alkyl group), $R^1(OCO_2CH_2CH_2)_nLi$ ($R^1$ is a C1 to C10 alkyl group, n is an integer from 1 to 25), $R^2(CH_2CH_2O)_mLi$ ($R^2$ is a C1 to C10 alkyl group, m is an integer from 1 to 25), and $NR^3R^4R^5$ ($R^3$, $R^4$, and $R^5$ are each C1 to C10 alkyl groups), and the inorganic material includes at least one selected from LiF, $Li_2O$, $Li_2CO_3$, and $Li_xPF_yO$ ($0 < x \leq 1$, $1 \leq y \leq 4$).

### Prior Art Literature

### Patent Documents

Patent Document 1: JP 2017-168466 A
Patent Document 2: JP 2013-232413 A

### Summary of Invention

### Problem to Be Solved by Invention

However, even when the negative electrode material for a lithium-ion battery of patent documents 1 and 2 is used, a battery having sufficient cycle characteristics cannot be obtained.

An object of the present invention is to provide a negative electrode capable of configuring a lithium-ion battery having excellent cycle characteristics.

### Means for Solving Problem

As a result of intensive examination to solve the above problems, the present inventors have found that a negative electrode for a lithium-ion battery having improved cycle characteristics may be obtained by defining a predetermined peak ratio in an X-ray photoelectron spectroscopy (XPS) spectrum of a surface of the negative electrode after charging and discharging, thus completing the present invention.

Configurations of the present invention are as follows.

[1] A negative electrode for a lithium-ion battery including carbon and silicon, wherein: the negative electrode has a silicon concentration in a negative electrode composite layer of 2 mass% or more and 80 mass% or less, a half-width of a peak on a (111) plane of Si is 3.0 deg. or more in an XRD pattern of the negative electrode using Cu-K$\alpha$ lines; a charge/discharge test is performed under the following conditions using a lithium-ion battery in which the negative electrode, a separator, and a positive electrode are laminated and an electrolytic solution in which a support lithium salt is dissolved in a carbonate ester solvent is used, and when a capacity maintenance rate of the battery is 95%; and when, in an X-ray photoelectron spectroscopy (XPS) spectrum of a negative electrode surface, a peak height near a binding energy of 528 eV is I528 (Ols), and a peak height near 531 eV is I531 (Ols), then I528 (O1s)/I531 (Ols) $\geq$ 0.1.

Here, the conditions of the charge/discharge test are as follows.

When a charging capacity of the positive electrode of the battery is C and a charging capacity of the negative electrode is A, then A/C = 1.01 to 1.34; an upper limit voltage when charging in the charge/discharge test is 3.8 to 4.5 V; and a lower limit voltage is 3.0 to 2.5 V.

[2] The negative electrode for a lithium-ion battery of [1], including composite particles including a carbon material and silicon as a negative electrode material constituting the negative electrode.

[3] The negative electrode for a lithium-ion battery of [1] or [2], wherein a positive electrode material in the positive electrode of the battery used in the charge/discharge test includes at least one type selected from $Li_xNi_aMn_bCo_cAl_dO_y$ ($0 < x \leq 1.1, 2 \leq y \leq 2.02, 0 \leq a \leq 1, 0 \leq b \leq 1, 0 \leq c \leq 1, 0 \leq d < 1, 0 < a + b + c + d \leq 1$), and $Li_zM_mPO_4$ ($0 \leq z \leq 1.1, 0.8 \leq m \leq 1.2$, and M is one or more type selected from Fe, Mn, Co, and Ni).

[4] The negative electrode for a lithium-ion battery of [1] to [3], wherein a temperature during aging in the charge/discharge test is 45°C and a current value is equivalent to 0.1 C.

[5] The negative electrode for a lithium-ion battery of [1] to [4], wherein a temperature during capacity confirmation in the charge/discharge test is 20°C and the current value is equivalent to 0.2 C.

[6] The negative electrode for a lithium-ion battery of [1] to [5], wherein a temperature during a charge/discharge cycle in the charge/discharge test is 20°C and the current value is 0.2 C.

[7] A lithium-ion battery provided with the negative electrode for a lithium-ion battery of [1] to [6], an electrolyte, and a positive electrode.

[8] A method for manufacturing a negative electrode material for a lithium-ion battery, including: a step for manufacturing composite particles including a carbon material and silicon by precipitating an Si-containing compound in pores of or on a surface and in the pores of the carbon material; and a step for causing a carbon source having an unsaturated bond to act on the composite particles at a lower temperature than that step.

[9] The method for manufacturing a negative electrode material for a lithium-ion battery of [8], further including: a step for attaching a lithium salt to a composite particle surface on which the carbon source having an unsaturated bond has been caused to act; a step for converting the lithium salt to lithium oxide by heating in the presence of hydrogen; and a step for further attaching an Si-containing compound and hydrosilylizing the composite particle surface by causing an unsaturated hydrocarbon to act.

[10] The method for manufacturing the negative electrode material for a lithium-ion battery of [9], wherein the lithium salt is lithium carbonate.

[11] A method for manufacturing a negative electrode material for a lithium-ion battery, including: a step for obtaining composite particles including a carbon material and silicon by precipitating an Si-containing compound in pores of or on a surface and in the pores of the carbon material; a step for attaching lithium alkoxide to a composite particle surface; and a step for attaching an Si-containing compound and hydrosilylizing the composite particle surface by causing an unsaturated hydrocarbon to act.

[12] A method for distinguishing a negative electrode having favorable cycle characteristics, wherein: a charge/-discharge test is performed using a lithium-ion battery in which a negative electrode, a separator, and a positive electrode are laminated and an electrolytic solution in which a support lithium salt is dissolved in a carbonate ester solvent is used, and when a capacity maintenance rate of the battery is 95%; and when, in an X-ray photoelectron spectroscopy (XPS) spectrum of a surface, a peak height near a binding energy of 528 eV is I528 (Ols), and a peak height near 531 eV is I531 (Ols), then a value of I528 (O1s)/I531 (Ols) is used.

Here, the conditions of the charge/discharge test are as follows.

When a charging capacity of the positive electrode of the battery is C and a charging capacity of the negative electrode is A, then: A/C = 1.01 to 1.34; an upper limit voltage when charging in the charge/discharge test is 3.8 to 4.5 V; and a lower limit voltage is 3.0 to 2.5 V.

[13] The method for distinguishing of [12], wherein the composite particles include a carbon material and silicon as a negative electrode material constituting the negative electrode.

[14] The method for distinguishing of [12] or [13], wherein a positive electrode material in the positive electrode of the battery used in the charge/discharge test includes at least one type selected from $Li_xNi_aMn_bCo_cAl_dO_y$ ($0 < x \leq 1.1$, $2 \leq y \leq 2.02$, $0 \leq a \leq 1$, $0 \leq b \leq 1$, $0 \leq c \leq 1$, $0 \leq d < 1$, $0 < a + b + c + d \leq 1$), and $Li_zM_mPO_4$ ($0 \leq z \leq 1.1$, $0.8 \leq m \leq 1.2$, and M is one or more type selected from Fe, Mn, Co, and Ni).

[15] The method for distinguishing of [12] to [14], wherein a temperature during aging in the charge/discharge test is 45°C and a current value is equivalent to 0.1 C.

[16] The method for distinguishing of [12] to [15], wherein a temperature during capacity confirmation in the charge/discharge test is 20°C and the current value is equivalent to 0.2 C.

[17] The method for distinguishing of [12] to [16], wherein a temperature during a charge/discharge cycle in the charge/discharge test is 20°C and the current value is 0.2 C.

**Effect of Invention**

By using the negative electrode of the present invention, it is possible to provide a lithium-ion battery having excellent cycle characteristics. Furthermore, according to the present invention, it is also possible to distinguish a negative electrode for a lithium-ion battery having good cycle characteristics.

**Embodiments of Invention**

Embodiments of the present invention will be described below.
In the present Specification, a lithium-ion battery is sometimes referred to simply as a "battery." Furthermore, "battery" usually indicates a rechargeable battery capable of being charged and discharged, but is not particularly limited.

[1] Negative electrode for a lithium-ion battery

The negative electrode for a lithium-ion battery of the present embodiment includes carbon and lithium, and a silicon concentration in a negative electrode composite layer is 2 mass% or more and 80 mass% or less, and in an XRD pattern of the negative electrode using Cu-K$\alpha$ lines, a half-width of a peak of the (111) plane of Si is 3.0 deg. or more.
For a battery using a negative electrode of the present, a charge/discharge test is performed using a battery in which the negative electrode, a separator, and a positive electrode are laminated and an electrolytic solution in which a lithium salt is dissolved in a carbonate ester solvent is used, and when a capacity maintenance rate of the battery is 95%; when, in an X-ray photoelectron spectroscopy (XPS) spectrum of a surface of the negative electrode, a peak height near a binding energy of 528 eV is I528 (Ols), and a peak height near 531 eV is I531 (Os1), then a ratio (I528 (O1s)/I531 (O1s)) fulfils the following relational formula.

$$I528\,(O1s)/I531\,(O1s) \geq 0.1 \qquad (1)$$

This I528 (O1s)/I531 (Ols) is preferably 0.2 or more, and more preferably 0.3 or more. Furthermore, this I528 (O1s)/I531 (Ols) is preferably 10 or less, and more preferably 9 or less. The negative electrode satisfying such a ratio has high cycle characteristics when a lithium-ion battery is configured.
A peak near a binding energy of 528 eV is thought to be an O1s peak caused by a Li oxide. Furthermore, a peak near a binding energy of 531 eV is thought to be an O1s peak caused by an oxoacid salt or carbonate salt of Li.

A scanning X-ray photoelectron spectrometer K-Alpha made by Thermo Scientific or the like, for example, may be used as an XPS analyzer.

The I528 (O1s)/I531 (Ols) ratio may be adjusted by changing a ratio of constituting elements of the negative electrode, a coat layer of the surface, manufacturing conditions, and the like.

In one embodiment of the present invention, when a battery for testing is assembled, the charge/discharge test performed, and the capacity maintenance rate of the battery is 95%, the evaluated I528 (O1s)/I531 (Ols) ratio is within the above range for the negative electrode recovered after disassembling the battery.

With current technology, there is a problem in that an amount ratio of carbon to silicon alone cannot be used to evaluate a fine internal structure, and thus the cycle characteristics of the negative electrode cannot be sufficiently understood. However, after performing a predetermined charge and discharge, the negative electrode is removed and evaluated by XPS, whereby it becomes possible to evaluate the cycle characteristics of the negative electrode.

Note that for the initial negative electrode, lithium oxide consumption on the surface is low, so there is little correlation between I528 (O1s)/I531 (Ols) and the cycle characteristics.

Furthermore, when the capacity maintenance rate of the battery is 95%, dismantling the battery and evaluating I528 (O1s)/I531 (Ols) for the recovered negative electrode may also be used as a method for detecting a negative electrode having excellent cycle characteristics.

A size of the battery, a configuration of the electrode including the positive electrode, a type of electrolyte, and the like do not affect I528 (O1s)/I531 (Ols) in XPS measurement. This characteristic is also a characteristic of the negative electrode that manifests through repeated charging and discharging, and is an indicator of the cycle characteristics.

In the battery for testing or in the battery of interest, the positive electrode preferably includes as a positive electrode material at least one type selected from $Li_xNi_aMn_bCo_cAl_dO_y$ ($0 < x \leq 1.1$, $2 \leq y \leq 2.02$, $0 \leq a \leq 1$, $0 \leq b \leq 1$, $0 \leq c \leq 1$, $0 \leq d \leq 1$, $0 < a + b + c + d \leq 1$), and $Li_zM_mPO_4$ ($0 \leq z \leq 1.1$, $0.8 \leq m \leq 1.2$, and M is one or more type selected from Fe, Mn, Co, and Ni).

A positive electrode composite layer also includes a conductivity aid and a coupling agent, and it is preferable that the positive electrode composite layer normally includes the positive electrode material at 92 to 99.8 mass%, the conductivity aid at 0.1 to 3 mass%, and the coupling agent at 0.1 to 5 mass%. These details will be described in the (negative electrode composite layer) section.

An electrolytic solution is used in which a support lithium salt is dissolved in a carbonate ester solvent.

The carbonate ester solvent preferably includes at least one type selected from ethylenecarbonate (EC), ethylmethylcarbonate (EMC), diethylcarbonate, propylenecarbonate (PC), diethylcarbonate (DEC), and dimethylcarbonate (DMC). For example, a mixed solvent of ethylenecarbonate, ethylmethylcarbonate, and diethylcarbonate may be used.

Examples of the support lithium salt include at least one type selected from the group consisting of $LiPF_6$, $LiBF_4$, LiFSI, and $LiAsF_6$. Furthermore, 0.1 mol/L to 5 mol/L is used as the concentration of the support lithium salt.

These are the positive electrode and electrolytic solution of a general lithium-ion battery, and commercial products may be used without particular limitations.

Here, the term "support lithium salt" refers to a lithium salt serving as a support electrolyte.

When performing the charge/discharge test, when a charging capacity of the positive electrode is C and a charging capacity of the negative electrode of the battery is A, it is necessary that A/C = 1.01 to 1.34 from the perspective of simultaneously suppressing lithium precipitation and improving energy density.

A/C may be calculated by a method described in the examples. That is, a cell is produced in which the negative electrode and positive electrode are each used for a test electrode (acting electrode) and lithium is the opposite electrode, and after charging and discharging are performed under predetermined charging and discharging conditions, the capacity of each test electrode (action electrode) may be calculated. Note that the aged battery, which will be described below, may be dismantled, the negative electrode and the positive electrode each removed, and A and C found by the above operation.

Furthermore, an upper limit voltage when charging in the charge/discharge test is 3.8 to 4.5 V, and a lower limit voltage is 3.0 to 2.5 V. This allows the active material of the positive and negative electrodes to sufficiently react.

The electrodes in the battery for the charge/discharge test may be changed according to the size of the battery, and are not particularly limited. Furthermore, the battery for the charge/discharge test may be configured at an interpolar distance such that a separator is used to prevent short-circuiting of the positive and negative electrodes, and preferably has a structure in which the positive electrode, separator, and negative electrode are laminated. Here, the separator thickness is usually about 5 $\mu$m to 30 $\mu$m.

In the present invention, the following battery is produced and the charge/discharge test performed. The type of carbonate ester solvent and the support lithium salt, the formulation ratio of the components of the positive electrode composite layer, A/C, the upper limit voltage and lower limit voltage, and the separator thickness may be within the above ranges. However, the capacity confirmation, aging, and charge/discharge test described below are performed according to the temperature, current value, and procedure described in the following example. Note that the type of positive electrode material, the size and number of electrodes laminated, and the amount of electrolytic solution are appropriately selected to the extent that a cycle test may be performed.

A separator (microporous film made of polypropylene, thickness: 5 to 30 $\mu$m) impregnated with an electrolytic solution is interposed and laminated between the negative electrodes and the positive electrode, the two single-surface coated negative electrodes having an electrode area of 21.84 cm$^2$ and the one both-surface coated positive electrode having an electrode area (single surface) of 20.0 cm$^2$ (positive electrode active material: NMC622, that is, Li-Ni$_{0.6}$Mn$_{0.2}$Co$_{0.2}$O$_2$, positive electrode material mass:conductivity aid mass:binder mass = 95:2:3). At this time, the negative electrode separator is interposed and laminated so as to oppose the positive electrode. The laminate is entirely wrapped in an aluminum laminated packaging material except for a tab, and 450 $\mu$L of the electrolytic solution is injected therein. Then, an opening is sealed by thermal fusion bonding to produce a laminated full cell for evaluation. This is used as a cell for testing.

Before the charge/discharge test, the following operation is performed as a battery aging process.

Specifically, constant current charging is performed at 45°C at a current value equivalent to 0.1 C from OCV (Open Circuit Voltage) to a predetermined upper limit voltage. This is switched to constant voltage charging at the time point when a predetermined upper limit voltage is reached. The cut-off condition is set as the time point at which the current value attenuated to a 0.02 C equivalent. Next, constant current discharge is performed at a current value equivalent to 0.1 C to a predetermined lower limit voltage. Constant current charging is performed again at a current value equivalent to 0.1 C from OCV to the upper limit voltage. This is switched to constant voltage charging at the time point when the upper limit voltage is reached. The cut-off condition is set as the time point at which the current value attenuated to a 0.05 C equivalent. Next, constant current discharge is performed at a current value equivalent to 0.1 C to the lower limit voltage. At this time point, gas removal treatment is performed.

Note that "current value equivalent to 0.1 C" is the magnitude of a current that fully discharges the capacity of the electrode calculated from the theoretical specific capacity of the active material included by the electrode and the mass included by the electrode in 10 hours.

The initial discharge capacity is found as follows. In the cell after aging, constant current charging is performed at a current value equivalent to 0.2 C from OCV to the upper limit voltage. This is switched to constant voltage charging at the time point when the upper limit voltage is reached. The cut-off condition is set as the time point at which the current value attenuated to a 0.02 C equivalent. Next, constant current discharge is performed at a current value equivalent to 0.2 C to the lower limit voltage. This charging and discharging is repeated 2 to 4 times. The second to fourth discharge capacity at this time is the initial discharge capacity (a).

Examining the initial discharge capacity is also referred to as "capacity confirmation."

The temperature at the time of capacity confirmation is set to 20°C. It is desirable that the charge/discharge test is usually performed in a constant temperature vessel.

The charge/discharge test is carried out as follows. In a cell where the initial discharge capacity is found, constant current charging is performed at a current value of 0.2 C up to the upper limit voltage. This is switched to constant voltage charging at the time point when the upper limit voltage is reached. The cut-off condition is set as the time point at which the current value attenuated to 0.02 C. Next, constant current discharge is performed at a current value of 0.2 C to the lower limit voltage.

When the discharge capacity of the nth charging and discharging is set to (b),
charging and discharging are repeated until the capacity maintenance rate = 100 $\times$ (b)/(a) = 95%.

The charge/discharge test is conducted at 20°C.

The current value during charging and discharging at a constant current in the charge/discharge test is 0.2 C (1 C is the magnitude of the current that fully discharges the aged discharge capacity in one hour).

The battery is disassembled after the charge/discharge test and the negative electrode is recovered. Next, after the negative electrode is cleaned using an organic solvent, the negative electrode is dried. The type of organic solvent is not particularly limited, but is specifically dimethyl carbonate or the like. Next, I528 (O1s) and I531 (O1s) are each measured by analyzing the negative electrode surface using an XPS analyzer.

(Negative Electrode Configuration)

The negative electrode for a lithium-ion battery of the present invention includes carbon and silicon.

The concentration of silicon in the negative electrode composite layer constituting the negative electrode is 2 mass% or more, preferably 5 mass% or more. Furthermore, the silicon concentration is 80 mass% or less, preferably 70 mass% or less. By having a silicon concentration within the above range, the battery may be made to have a high capacity.

Note that "negative electrode composite layer" generally consists of a negative electrode material, a binder, and a conductivity aid as an optional component. The negative electrode according to the present embodiment has a configuration in which a negative electrode composite layer composed of a negative electrode material, a binder, and a conductivity aid as an optional component is provided on a current collector.

It is preferable that particles including a carbon material and silicon are used as the negative electrode material in the negative electrode composite layer. The particles may each individually include particles composed of a carbon material and silicon particles, or may be composite particles including a carbon material and silicon. The negative electrode composite layer may further include a material including hard carbon and/or graphite as the negative electrode material.

Here, "negative electrode material" refers to a compound of the negative electrode active material or the negative electrode active material together with another material. The "other material" may be the negative electrode active material.

The silicon content of the particles is 30 mass% or more, preferably 40 mass% or more, and is 80 mass% or less, preferably 70 mass% or less based on the particle mass. When silicon is included at this content, the battery may be made to have a high capacity.

The silicon content of the particles may be measured by SEM-EDS of a particle cross-section.

The particles preferably include oxygen as another element. It is preferable that the oxygen content in the particles is 0.2 mass% or more and 10.0 mass% or less.

Pure Si has a high activity, and therefore rapid deterioration of the particles may be suppressed by oxidizing a portion thereof and reducing the activity thereof, and because the particles include a metal oxide, it is preferable that the oxygen content is 0.2 mass% or more. From the same perspective, it is more preferable that the oxygen content is 0.3 mass% or more, even more preferable that it is 0.4 mass% or more, particularly preferable that it is 0.5 mass% or more, and most preferable that it is 0.6 mass% or more.

When the oxygen content is 10.0 mass% or less, irreversible capacity when used as the negative electrode material may be reduced by moderately suppressing oxidation of silicon. From the same perspective, the content is more preferably 7.0 mass% or less, and even more preferably 5.0 mass% or less.

The oxygen content is found, for example, by SEM-EDS in a particle cross section.

In the present Specification, "composite particles including a carbon material and silicon" (hereinafter also referred to as "Si/C particles") are particulate matter including silicon (Si) on the surface and/or inside of the carbon material. The carbon material is preferably porous carbon, and more preferably amorphous carbon. Furthermore, it is preferable that the silicon is included in at least the pores of the porous carbon. "Porous carbon" is carbon having pores. It is preferable that a fine Si domain be formed uniformly inside the carbon material. "Si domain" refers to a region where silicon is present. Due to the Si/C particles having this structure, expansion and contraction associated with charging and discharging occurs isotropically, and thus cycle characteristics are improved. This structure may be distinguished by observing cross-sectional SEM-EDS of Si/C particles. When, inside the composite particles, distributions of silicon and carbon overlap, a fine Si domain at or below the spatial resolution of the SEM-EDS is understood to be dispersed uniformly.

Note that EDS is energy-dispersed X-ray spectroscopy, SEM-EDS is irradiating electron beams on a sample during SEM observation, thereby releasing core electrons of an element constituting the sample, and from light (characteristic X-rays) having energy corresponding to an energy gap released when electrons in a higher energy level fall into an empty path, measuring an energy and number of photons of these characteristics X-rays, finding the type of element and number of atoms from this, and finding the content (mass%) of each element from the ratio of number of atoms and atomic weight of each element.

The negative electrode composite layer may also, for example, include other elements such as lithium. These may be included as composite particles or may be present in a coat layer formed on the surface of the composite particles. In this case, the lithium is preferably included as lithium oxide. Lithium oxide may also be introduced into composite particles from the lithium salt and carbonate ester solvent during charging and discharging, and these are also contained in the lithium.

Note that the coat layer itself includes carbon, and preferably includes a compound derived from a hydrocarbon.

By including lithium oxide in the negative electrode composite layer, it is possible to trap $CO_2$ generated by decomposition of the electrolytic solution and to suppress cell expansion. It is desirable that the lithium oxide is not exposed to the negative electrode surface, and thus the lithium oxide surface may have carbon present or silicon having a hydrosilyl group formed on the surface present. By adopting such a structure, the carbonatization of lithium oxide may be suppressed, the effect is long-lasting, and lithium oxide may be used continuously as a carbon dioxide gas trap during a charging and discharging cycle. Therefore, by using such a negative electrode, the cycle characteristics of the lithium-ion battery may be improved.

The presence of lithium oxide may be confirmed, for example, by elemental analysis such as X-ray photoelectron spectroscopy (XPS) or by identification of peaks of a crystal of XRD.

The total content of oxygen and lithium as elements of the composite particles is 0.01 parts by mass or more, preferably 0.1 parts by mass or more, and more preferably 0.2 parts by mass or more in 100 parts by mass of the composite particles. When the content is within the above range, it is possible to suppress the decrease in cycle characteristics of the battery.

These contents are found, for example, from elemental analysis such as XPS and ICP-AES. It is preferable that the surface of the lithium oxide has an Si layer is formed thereon and that on the surface thereof, a hydrosilyl group is introduced. The hydrosilyl group may be partially oxidized.

In an XRD pattern using the Cu-K$\alpha$ lines of the negative electrode (horizontal axis: 20, vertical axis: Intensity), a half-width of a peak of the (111) plane of Si is 3.0 deg. or more. When the half-width of the peak of the (111) plane of Si is 3.0 deg. or more, this leads to suppression of silicon cracking due charging because the crystals are small. This leads to an improvement in the first Coulomb efficiency and Coulomb efficiency in lithium-ion batteries. From the same perspective, the half-width is preferably 3.5 deg. or more, and more preferably 4.0 deg. or more. Furthermore, the half-width is preferably 10.0 deg. or less, more preferably 9.0 deg. or less, and even more preferably 8.0 deg. or less.

(Method for Manufacturing Negative Electrode Material for a Lithium-ion Battery)

A method for manufacturing a negative electrode material of the present embodiment includes: a step for manufacturing composite particles including a carbon material and silicon by precipitating an Si-containing compound in pores of or on a surface and in the pores of the carbon material; and a step for causing a carbon source having an unsaturated bond to act on the composite particles at a lower temperature than that step.

• Step for Manufacturing Composite Particles

For example, composite particles are manufactured using a carbon material as one raw material, but the carbon material used as a raw material for the composite particles, that is, "raw carbon," is not particularly limited.

• Preparation of Raw Carbon

The raw carbon is preferably activated to form a porous carbon. Porous carbon is carbon having a total pore volume of 0.20 cm$^3$/g or more or a BET specific surface area of 200 m$^2$/g or more. Porous carbon is thought to have a high adsorption rate of silane, and thus fine silicon may be precipitated in pores when manufacturing composite particles using, for example, CVD using silane gas. The shapes include granular or fibrous, and granular is preferable. This is because when granular, pores are formed isotropically, and composite particles expand and contract isotropically during lithiation and delithiation, resulting in excellent cycle characteristics. In order to perform isotropic expansion and contraction, it is preferable to have a smaller aspect ratio of the particles, and it is further preferable to have a spherical shape (circular cross-section). Examples of porous carbon include activated carbon. Note that activated carbon is usually amorphous carbon.

The raw carbon described above is preferably carbonized from a phenol resin or a copolymer resin of resorcinol and formaldehyde. Prior to carbonization, the resin may be cured by heat treatment at 150°C to 300°C for 1 to 6 hours. After curing, the resin may be crushed to a particle size of about 0.5 to 5.0 mm. Preferably, the above resin is made by carbonization by being held in an inert gas atmosphere at a temperature of 400°C to 1,100°C for 1 to 20 hours.

It is preferable that Dv50, which is the 50% particle diameter in the volume-based cumulative particle size distribution of the raw carbon, be 1.0 $\mu$m or more and 20 $\mu$m or less.

By having a Dv50 of 1.0 $\mu$m or more, side reactions of the composite particles with the electrolytic solution are reduced. Furthermore, it is easy to prepare a slurry whose powder has excellent handling properties and has suitable viscosity and density for coating, and it is also easy to increase the density when used as an electrode.

From this perspective, Dv50 is more preferably 2.0 $\mu$m or more, and even more preferably 3.0 $\mu$m or more. By Dv50 being 20.0 $\mu$m or less, expansion and contraction during charging and discharging of the battery are suppressed, and the cycle characteristics are improved. In addition, the smaller the particle size of the composite particles, the lower the resistance and the better the rate characteristics due to the increased area where reaction with lithium ions is possible. From the same perspective, Dv50 is more preferably 15.0 $\mu$m or less, and even more preferably 10.0 $\mu$m or less.

Without a strong grinding step or a classification step being applied to the raw carbon, the Dv10, Dv50, and Dv90 remain substantially the same even for the raw carbon and for the composite particles after silicon precipitation described below.

• Silicon Compositing

An Si-containing gas is made to act on the heated carbon material to precipitate the Si-containing compound in the pores of or on the surface and in the pores of the carbon material to obtain composite particles including the carbon material and silicon.

Specifically, the Si-containing compound is precipitated in the pores of and/or on the surface of the carbon material by thermal decomposition of the Si-containing gas occurring in the pores of the carbon material or the like, thereby obtaining composite particles.

For example, when the carbon material is placed in a chamber of the CVD device and the silane gas is made to act on the carbon material in a heated state, the silane enters the inside of the pores of the carbon material, and the silane may be precipitated in the pores of the carbon material by further thermal decomposition. The device or method indicated in US 10,424,786, for example, may be used as a method for achieving this.

It is preferable for silicon to be present within the pores of the carbon material, as this enhances the durability of the composite particles against the stresses associated with the expansion and contraction of silicon during battery charge and discharge. Moreover, it is preferable that the diameter of the pores where the silicon precipitates is less than 3 nm. Silicon precipitated in pores less than 3 nm in diameter suppresses the formation of crystalline lithium silicide when charged and discharged, and dramatically improves cycle characteristics. From this perspective, the carbon material is preferably a porous carbon material having many pores having a diameter of less than 3 nm.

Silane ($SiH_4$) gas is preferable as the Si-containing gas used. In addition to silane gas, for example, disilane gas, trisilane gas, and the like may also be used. Furthermore, the Si-containing gas may include other gases, and for example, a gas such as nitrogen, argon, helium, or hydrogen may be mixed as the carrier gas. The various conditions of the CVD, such as gas composition ratio, gas flow rate, temperature program, and fixed bed/fluidized bed selection, are adjusted as appropriate while observing the properties of the product.

When silane gas is used, the treatment temperature is 340°C to 450°C, more preferably 350°C to 420°C, and further preferably 370°C to 400°C. By using this temperature range, silicon may be preferentially precipitated in pores having a diameter of less than 3 nm of the carbon material.

When silane gas is used, it is preferable that the pressure inside the furnace during silicon precipitation is 1,500 torr or less. By the pressure in the furnace being 1,500 torr or less, silicon may be preferentially precipitated in pores having a diameter of less than 3 nm. From the same perspective, it is more preferable that the pressure in the furnace is 1,000 torr or less, and it is further preferable that the pressure is 900 torr or less.

Furthermore, the Si-containing compound may be precipitated in the pores of or in the pores and on the surface of the carbon material, and after the composite particles are obtained, a portion of the Si-containing compound may be oxidized by bringing into contact with an inert gas atmosphere containing oxygen. In particular, pure Si is highly active, and thus rapid deterioration of composite particles may be suppressed by oxidizing a portion.

• Process for causing a carbon source having an unsaturated bond to act

A carbon source having an unsaturated bond is caused to act on the composite particles at a lower temperature than in that step. It is thought that a coat layer is formed on the surface of the composite particles.

A hydrocarbon having a double or triple bond may be used as a carbon source having an unsaturated bond. When the hydrocarbon is a compound that does not gasify at normal pressure due to low vapor pressure, the hydrocarbon may be used at a pressure lower than normal pressure. Preferable examples include acetylene, ethylene, propylene, and 1,3-butadiene, which are gases at normal pressure, acetylene and ethylene being more preferable. At this time, a plurality of hydrocarbon types may be used. Moreover, it is permissible to mix and use an inert gas such as helium or argon, or a reducing gas such as hydrogen.

The temperature may be lower than that of the above step, and is preferably 150 to 400°C, and is more preferably in the range of 300 to 350°C.

• Adhesion of lithium source

When lithium oxide is included, a lithium salt or lithium alkoxide, which is a lithium source, is attached to the composite particles having a coat layer. Alternatively, lithium alkoxide is attached to composite particles without a coat layer. Note that, as described above, the coat layer may include lithium oxide. When the coat layer includes lithium oxide, a lithium salt or lithium alkoxide may be attached to the composite particles having the coat layer and then converted to lithium oxide. Furthermore, when lithium alkoxide is attached to composite particles having no coat layer and then heat treatment is performed, decomposition of the lithium alkoxide may also form a coat layer including lithium oxide. Therefore, when lithium alkoxide is used, a preferred aspect is to directly attach the lithium source to form a coat layer without causing the carbon source to act.

Examples of lithium salts include $Li_2CO_3$, $(COOLi)_2$, $CH_3CH(OH)COOLi$, and the like. Of these, $Li_2CO_3$ is preferable. Furthermore, examples of lithium alkoxide include lithium tetraisopropoxide, lithium butoxide, lithium pentoxide, and the like.

For adhesion, the salt or alkoxide dissolution liquid may be brought into contact with the surface of the composite particles where the coat is formed, as necessary. The solvent is selected from water or an organic solvent, and a solvent having a boiling point of around 100°C such as ethanol, isopropyl alcohol, butanol, hexane, or toluene is preferable.

For example, the solution is sprayed by heating composite particles in an inert gas atmosphere in a fluid state. The method for entering the fluid state is not particularly limited, but a method using a tumbling fluidized bed or a circulating fluidized bed is given, and a method using a tumbling fluidized bed is preferable. For example, an MP series made by Powrex may be mentioned as the device for the tumbling fluidized bed.

When using a tumbling fluidized bed, it is preferable to operate at an air supply temperature of 120°C or higher, depending on the type of solvent. By being within this range, it becomes easier to maintain fluidity.

When using a tumbling fluidized bed, it is preferable to perform this in a low humidity atmosphere. Examples of the low humidity atmosphere include a nitrogen gas atmosphere, an argon gas atmosphere, an atmospheric atmosphere having a humidity of 25% or less, or the like.

The air supply volume of the tumbling fluidized bed is not limited, but conditions under which the composite particles flow are preferable. The method of spraying the solution onto the composite particles is not particularly limited, but for example, a method using a tube pump and a spray nozzle may be mentioned.

It is also possible to perform a heat treatment or sol-gel reaction on the lithium salt or lithium alkoxide attached to the composite particles described above, but the heat treatment or sol-gel reaction may or may not be performed because the heat treatment is then performed in the presence of hydrogen.

Composite particles to which the lithium salt or lithium alkoxide are attached are heated in the presence of hydrogen to convert into lithium oxides. This method may be performed by the method described in JP 5950160 and the like.

The concentration of hydrogen brought into contact with the composite particles is preferably 0.1 vol% or more, more preferably 0.5 vol% or more, and even more preferably 1.0 vol% or more. When it is 0.1 vol% or more, the reaction proceeds under increased pressure from normal pressure, which is preferable.

The hydrogen may be mixed and supplied with an inert gas to obtain an appropriate partial pressure. Noble gases such as nitrogen, helium, neon, argon, krypton, xenon, and radon are preferably used as inert gases. Nitrogen is particularly preferable in terms of cost. When hydrogen is mixed and supplied with an inert gas, it is preferable that the concentration of hydrogen included in the inert gas be 0.1 vol% or more. This is more preferably 0.5 vol% or more, and even more preferably 1 vol% or more. When it is 0.1 vol% or more, the reaction proceeds under increased pressure from normal pressure, which is preferable.

The reaction temperature is preferably 400°C to 450°C. 400 to 430°C is more preferably. 400°C to 420°C is even more preferable. At temperatures within this range, the reaction proceeds sufficiently.

Furthermore, in the case of alkoxide, when hydrolyzed or heated, lithium oxide is produced, and thus there is not necessarily a need to perform treatment under the hydrogen.

• Hydrosilylation

An Si-containing gas such as silane gas may be adhered to the composite particles to which lithium oxide is introduced and pyrolyzed to precipitate the Si-containing compound onto the surface of the composite particles. The precipitation conditions of the Si-containing compound are as described above. After precipitation of the Si-containing compound, the surface may be hydrosilylized by causing the unsaturated hydrocarbon to act on the composite particles at a low temperature of 400°C or less. After hydrosilylation, the surface may further be subjected to an oxidation treatment.

Oxidation can be performed by bringing into contact with a gas including oxygen (more specifically, an oxidizing gas). A gas including oxygen preferably has an oxygen concentration of 1 to 25 vol%, more preferably 1 to 20 vol%, and even more preferably 5 to 20 vol%. In that case, the oxygen is diluted using argon or nitrogen. Air may be used as a gas including oxygen, but to perform stable oxidation, it is preferable that the humidity of the air be adjusted and kept constant.

The temperature when brought into contact with the gas containing oxygen, is preferably equal to or higher than room temperature and 200°C or less. Above 200°C, more silicon oxidation than necessary may occur.

The reaction time, that is, the time for bringing the coat layer into contact with a gas including oxygen, is, for example, 0.1 to 120 hours.

It is preferable that heat treatment be performed in an inert gas atmosphere or under low pressure after bringing into contact with the gas including oxygen. The temperature during heat treatment is preferably 400°C or below. It is thought that the unreacted Si-H group may be decomposed by heat treatment at 400°C or lower.

Note that when pyrolytic GC-MS measurement is performed on the composite particles and the gas generated from the composite particles includes hydrocarbon-derived compounds between 200°C and 600°C, it may be distinguished that the coat layer exists on the surface of the composite particles.

As described above, only one type may be used or a mixture of a plurality of types may be used as the negative electrode material. The negative electrode of the present embodiment must include carbon and silicon, but a particularly preferred embodiment includes composite particles including carbon and silicon as a component.

(Other Negative Electrode Materials)

In the negative electrode of the present embodiment, the composite particles described above are included as the negative electrode material. The composite particles may be used by mixing two or more types. Further other components may be included. Examples of other components include those commonly used as negative electrode materials in lithium-ion rechargeable batteries. For example, graphite, hard carbon, soft carbon, lithium titanate ($Li_4Ti_5O_{12}$), silicon, tin, and other alloy-based active materials, a composite material of these, and the like may be mentioned. These components are usually used in particle form. One type of a component other than the composite particles may be used, or two or more types may be used. Among these, graphite particles and hard carbon are particularly preferably used.

When other components are included to form the negative electrode material, it is preferable to adjust the composite particles to 1 to 50 mass% in the negative electrode material. This is more preferably adjusted to 2 to 25 mass%. By mixing another carbon material or conductivity aid, it is possible to create a negative electrode material that maintains the excellent properties of the composite particles while also possessing the excellent properties of another carbon material. When using a plurality of types of materials as negative electrode materials, such may be used after mixing in advance, or may be added sequentially when preparing the slurry for forming the negative electrode composite layer, as described later.

Commercially available mixers and stirrers may be used as a device for mixing composite particles with other materials. Specific examples include mixers such as mortars, ribbon mixers, V-type mixers, W-type mixers, one-blade mixers, and Nauta mixers.

(Negative Electrode Composite Layer)

The negative electrode includes a negative electrode composite layer including the above negative electrode material. The negative electrode composite layer generally includes a negative electrode material and a binder. A conductivity aid may be included as an optional component.

The method for manufacturing the negative electrode composite layer may utilize a known method such as, for example, that illustrated below. Using the negative electrode material, binder, conductivity aid as an optional component, and solvent, a slurry is prepared to form the negative electrode composite layer. The slurry is coated onto a current collector such as a copper foil and dried. This is further vacuum dried to remove the solvent. The obtained product may be referred to as a negative electrode sheet. The negative electrode sheet consists of the negative electrode composite layer and the current collector. The negative electrode sheet is cut or punched into a required shape and size, then pressed to increase the density of the negative electrode composite layer (which may be referred to as negative electrode density). An energy density of the battery increases when electrode density is increased. The pressing method is not particularly limited as long as the process may achieve a desired negative electrode density, but uniaxial pressing, roll pressing, and the like may be mentioned. In an example that follows, a step of performing pressing after shape processing is exemplified, but shape processing may be performed after pressing. An electrode in a desired shape and negative electrode density is referred to as a negative electrode in the present invention. The negative electrode may also further include that in a state in which a current collector tab is attached to a current collector as needed.

Any binder commonly used in the negative electrode composite layer of a lithium-ion battery may be freely selected as a binder. Examples include polyethylene, polypropylene, ethylenepropylene terpolymer, butadiene rubber, styrene-butadiene rubber (SBR), butyl rubber, acrylic rubber, polyvinylidene fluoride (PVdF), polytetrafluoroethylene (PTFE), polyethylene oxide, polyepichlorohydrin, polyphosphazene, polyacrylonitrile, carboxymethyl cellulose (CMC), carboxymethyl cellulose salts, polyacrylic acid, polyacrylamide, and the like. One type of binder may be used, or two or more types may be used. The amount of binder is preferably 0.5 to 30 parts by mass relative to 100 parts by mass of the negative electrode material.

The conductivity aid is not particularly limited so long as it serves to impart electronic conductivity and dimensional stability (the ability to buffer against volume changes due to the insertion and removal of lithium) to the electrode. Examples include carbon nanotubes, carbon nanofibers, vapor-phase carbon fibers (for example, "VGCF (registered trademark)-H" produced by Resonac Corporation), conductive carbon black (for example, "Denka Black (registered trademark)" produced by Denka Co., Ltd., "SUPER C65" produced by Imerys Graphite & Carbon, and "SUPER C45" produced by Imerys Graphite & Carbon), conductive graphite (for example, "KS6L" produced by Imerys Graphite & Carbon, and "SFG6L" produced by Imerys Graphite & Carbon), and the like. A plurality of types of these may be used.

Carbon nanotubes, carbon nanofibers, or vapor-phase carbon fibers are preferably included as the conductivity aid, and a fiber length of these conductivity aids is preferably 1/2 of the Dv50 of the composite particles. When the fiber length is a length in this range, these conductivity aids serve as a bridge between the negative electrode active materials including the composite particles, improving cycle characteristics. Moreover, single-wall type or multi-wall type carbon nanotubes having a fiber diameter of 15 nm or less are preferable from the perspective of increasing the number of bridges at the same amount of addition. Furthermore, being more flexible, such is preferable from the perspective of improving negative electrode density.

The amount of the conductivity aid when preparing the slurry for electrode coating is preferably 1 to 30 parts by mass relative to 100 parts by mass of the negative electrode material.

There are no particular restrictions on the solvent used when preparing the slurry for electrode coating, and examples include N-methyl-2-pyrrolidone (NMP), dimethylformamide (DMF), isopropyl alcohol, tetrahydrofuran (THF), water, and the like. In the case of a binder using water as a solvent, it is also preferable that a thickener be used in combination. The amount of solvent may be adjusted to a viscosity that allows the slurry to easily coat the current collector.

[2] Lithium-ion Battery

The lithium-ion battery according to the present invention is provided with a negative electrode including a negative electrode material for a lithium-ion battery, an electrolyte, and a positive electrode. A general configuration found in a usual lithium-ion battery may be used for a configuration other than the negative electrode in the lithium-ion battery.

As described above, the negative electrode is composed of a negative electrode composite layer and a current collector.

Furthermore, the positive electrode is composed of a positive electrode composite layer and a current collector.

Examples of the forms of each electrode include laminates and coiled bodies, but are not particularly limited.

The positive electrode composite layer usually consists of a positive electrode material, a conductivity aid, and a binder.

There are no particular restrictions on material for the positive electrode material, as long as the material allows for reversible electrochemical lithium insertion/extraction and has a standard oxidation reduction potential of these reactions sufficiently higher than that of the standard oxidation reduction potential of a negative electrode reaction. Examples include $LiCoO_2$, $LiNiO_2$, $LiMn_2O_4$, $LiCo_{1/3}Mn_{1/3}Ni_{1/3}O_2$, $LiCo_{0.6}Mn_{0.2}Ni_{0.2}O_2$, $LiCo_{0.8}Mo_{0.1}Ni_{0.1}O_2$, carbon-coated $LiFePO_4$, or suitable mixtures thereof.

Items mentioned in the negative electrode section may be used as the conductivity aid, binder, and solvent for slurry preparation. Aluminum foil is preferably used as the current collector for the positive electrode.

The electrolyte used in the lithium-ion battery may be an electrolyte that is well known as an electrolyte for the lithium-ion battery.

Specifically, a non-aqueous electrolytic solution in which at least one type of lithium salt selected from $LiPF_6$, $LiBF_4$, LiFSI, and $LiAsF_6$ is dissolved in at least one type of solvent selected from the group consisting of ethylene carbonate (EC), propylene carbonate (PC), ethylmethylcarbonate (EMC), diethylcarbonate (DEC), and dimethylcarbonate (DMC) may be used.

Furthermore, a small amount of an additive commonly used in electrolytic solution for lithium-ion batteries may be added to the non-aqueous electrolytic solution. Examples of such additives include vinylene carbonate (VC), biphenyl, propanesultone (PS), fluoroethylene carbonate (FEC), ethylene sultone (ES), and the like. Preferable examples include VC and FEC. The amount of addition is preferably 0.01 to 20 mass% relative to 100 mass% of the non-aqueous electrolytic solution.

A battery according to one embodiment of the present invention includes a battery case provided with a separator between both electrodes and housing these.

Any material that can be used in a typical lithium-ion battery may be freely selected as a separator, including combinations thereof, such as a microporous film made of polyethylene or polypropylene. Such separators may also have particles such as $SiO_2$ and $Al_2O_3$ mixed as fillers or adhered to the surface.

There are no particular restrictions for a battery case, as long as the positive and negative electrodes, separator, and electrolytic solution can be accommodated. In addition to commercially available battery packs, cylindrical cells of type 18650, coin-type cells and the like, other standardized forms in the industry, and those packed in aluminum packaging, and the like may be freely designed and used.

Each electrode may be stacked and packed for use. Moreover, single cells may be connected in series and used as batteries and modules.

The lithium-ion battery of the present invention may be used as: a power source for electronic devices such as smartphones, tablet computers, mobile information terminals; a power source of an electric motor for power tools, vacuum cleaners, electric bicycles, drones, electric vehicles, and the like; and storage for electricity obtained from fuel cells, solar power generation, wind power generation, and the like.

[3] Method for Distinguishing Negative Electrodes

According to the present embodiment, a method for distinguishing a negative electrode having favorable cycle characteristics is also provided.

That is, a method for distinguishing wherein a charge/discharge test is performed using a lithium-ion battery in which a negative electrode, a separator, and a positive electrode are laminated and an electrolytic solution in which a support lithium salt is dissolved in a carbonate ester solvent is used, and when a capacity maintenance rate of the battery is 95%, when, in an X-ray photoelectron spectroscopy (XPS) spectrum of a surface, a peak height near a binding energy of 528 eV is I528 (Ols), and a peak height near 531 eV is I531 (Ols), then a value of I528 (O1s)/I531 (Ols) is used. The I528 (O1s)/I531 (Ols) value is set appropriately according to the battery used.

For example, it may be distinguished that I528 (O1s)/I531 (O1s) ≥ 0.1 is a negative electrode having favorable cycle characteristics.

Note that "near" refers to a range of ± 1 eV.

The battery may be a commercially assembled battery, or an assembled battery in which a negative electrode, a positive electrode, and the like are each purchased. The battery may be a battery whose negative electrode material, positive electrode material and other members are produced and arranged, and the negative electrode and positive electrode are prepared and assembled.

As described in the section of the negative electrode, the temperature at the time of capacity confirmation in the charge/discharge test is 20°C and the current value is equivalent to 0.2 C. By providing this condition, it is possible to correctly distinguish cycle characteristics.

The charge/discharge test is as described above for the negative electrode, and the upper limit voltage during charging is 3.8 V to 4.5 V, and the lower limit voltage is 3.0 V to 2.5 V. By performing a charge/discharge test under this condition, it is possible to correctly distinguish the cycle characteristics of the negative electrode.

Combinations of the positive electrode and negative electrode are not particularly limited.

In the above method for distinguishing, when the charging capacity of the positive electrode of the battery is set to C and the charging capacity of the negative electrode is set to A, correct distinguishing is possible by combining electrodes where A/C = 1.01 to 1.34.

The present invention is preferable because it can be effectively distinguished when the negative electrode material constituting the negative electrode includes composite particles including a carbon material and silicon.

Furthermore, it is preferable when the positive electrode material in the positive electrode includes at least one type selected from $Li_xNi_aMn_bCo_cAl_dO_y$ ($0 < x \leq 1.1, 2 \leq y \leq 2.02, 0 \leq a \leq 1, 0 \leq b \leq 1, 0 \leq c \leq 1, 0 \leq d < 1, 0 < a + b + c + d \leq 1$), and $Li_zM_mPO_4$ ($0 \leq z \leq 1.1, 0.8 \leq m \leq 1.2$, and M is one or more type selected from Fe, Mn, Co, and Ni) because the present invention is able to effectively distinguish. Similarly to the negative electrode, in the method for distinguishing, it is preferable that the temperature during the charge/discharge cycle in the charge/discharge test is 20°C and the current value is 0.2 C. Furthermore, it is preferable that the temperature during aging in the charge/discharge test is 45°C and the current value is equivalent to 0.1.

**Examples**

The present invention will be described in detail below by presenting an example and comparative examples, but the present invention is not limited to these examples. The measurement of material properties and evaluation of battery properties were conducted as follows.

[Example 1]

1. Production of carbon material

400 g of carbide of a spherical phenol resin having a 50% particle size (Dv50) of 5 μm in a cumulative particle size distribution based on volume was heated to 950°C in an inert gas atmosphere, switched to $CO_2$ gas, and held for 4.0 hours to obtain porous carbon.

2. Production of composite particles

17 g of the porous carbon was placed in a CVD device and $SiH_4$ was made to act at 400°C for 3.0 hours to precipitate an Si-containing compound on the surface and in the pores of the porous carbon to obtain composite particles including the porous carbon and silicon. Then, after residual $SiH_4$ was discharged, acetylene gas was made to act at 350°C for 2.0 hours (low temperature hydrocarbon treatment). Thereafter, dry air was made to act at 200°C for 1.0 hours.

3. Lithium carbonate coat

For 200 g of obtained Si/C composite particles, 10 g of an aqueous 1 wt% $Li_2CO_3$ solution was loaded into a tumbling fluidized coating device (MP-01_mini, made by Powrex) and subjected to dry mixing until the solution was completely sprayed.

(Operating Conditions of the Tumbling Fluidized Coating Device)

• Rotors: Standard

- Filter: FPM

- Mesh: 800 M

- Nozzle type: NXP-II

- Nozzle diameter: 1.2 mm

- Nozzle position: Tangent line

- Nozzle count: 1

- Rotor rotation speed: 400 rpm

- Spray air pressure: 0.17 (MPa)

- Brush-off pressure: 0.2 (MPa)

- Filter brush-off time/interval: 4.0/0.3 (s/s)

- Air supply volume: 0.2 m$^3$/min

- Spray speed: 1.0 g/min

- Air supply temperature: 120°C

- Atmosphere: Air

- Temperature: 20°C

- Time: 20 minutes (including drying after spraying)

4. Conversion of lithium carbonate

The CVD device was filled with 17 g of composite particles to which lithium carbonate was attached. A gas supplying tube and exhaust tube were attached to an upper and lower portion of a reactor, and 200 mL/min of 3% hydrogen-containing nitrogen gas (made by Taiyo Nippon Sanso JFP) was introduced from the gas supplying tube at the lower portion of the reactor, and the mixture is heated to 400°C by external heating. After confirming that the temperature reached 400°C, the reaction was carried out at atmospheric pressure for 42 hours while letting atmospheric gas flow. After the completion of the reaction, the mixture was cooled to room temperature. Thus, lithium carbonate was converted to lithium oxide.

The Si-containing compound was precipitated on the surface of the composite particles by causing $SiH_4$ to act at 400°C for 5.0 minutes while the CVD device was filled with composite particles including lithium oxide (the Si-containing compound layer was made to be less than 10 nm).

Then, after residual $SiH_4$ was discharged, acetylene gas was made to act at 350°C for 2.0 hours and the surface was hydrosilylized (hydrosilylation).

Using the above composite particles, a battery was produced and evaluated as follows.

Battery production

Production of Negative Electrode Sheet

[1] Styrene butadiene rubber (SBR) and carboxymethylcellulose (CMC) were used as binders.

Specifically, an aqueous SBR dispersion in which solid content 40 mass% of SBR was dispersed and an aqueous CMC solution in which 2 mass% of CMC powder was dissolved were used.

A mixture of carbon black (SUPER C45 (registered trademark), made by Imerys Graphite & Carbon) and single-layer carbon nanotubes (WPB-030, made by OCSiAl) was prepared in a 5:1 mass ratio as a mixed conductivity aid.

An aqueous CMC solution made to have 10.0 parts by mass of composite particles, 86.4 parts by mass of graphite particles (Dv50: 12 $\mu$m), 0.6 parts by mass of a mixed conductivity aid, and a CMC solid content of 1.5 parts by mass, and an SBR aqueous dispersion having a SBR solid content of 1.5 parts by mass were mixed, an appropriate amount of water for viscosity adjustment was added thereto, and the mixture was kneaded in a planetary centrifugal mixer (made by Thinky Corporation) to obtain a slurry for forming a negative electrode composite layer. Slurry concentration is 45 to 55 mass%.

The slurry for forming the negative electrode composite layer was uniformly applied on a 20 $\mu$m thick copper foil serving as a current collector foil using a 75 $\mu$m gap doctor blade, dried using a hot plate, and dried in vacuum at 70°C for 12 hours to form the negative electrode composite layer on the current collector foil. This is referred to as a negative electrode sheet (sheet composed of a negative electrode composite layer and a current collector). The weight was about 3 mg/cm$^2$. The obtained sheet composed of the negative electrode composite layer and the current collector was adjusted to a negative electrode composite layer density of 1.2 to 1.3 g/cm$^3$ using a roll press, and the area of the composite layer applied portion was 21.84 cm$^2$ (4.2 cm x 5.2 cm), and the composite layer unapplied portion (= tab portion) was 1.5 cm$^2$ (1.0 cm x 1.5 cm), thereby obtaining the negative electrode. Silicon concentration in the negative electrode composite layer was 5.0 mass%.

The electrode density of the negative electrode (negative electrode density) was calculated as follows. The mass and thickness of the negative electrode obtained by the above method were measured, and the mass and thickness of the current collector, which had been punched out to 16 mmø and separately measured, were subtracted to obtain the mass and thickness of the negative electrode composite layer, and the electrode density (negative electrode density) was calculated from this value.

Positive Electrode Preparation

95 g of LINi$_{3/5}$Mn$_{1/5}$Co$_{1/5}$O$_2$ (Dv50:11 $\mu$m), 3 g of carbon black (SUPER-C65 made by Imerys Graphite & Carbon) as a conductivity aid, 2 g of polyvinylidene fluoride (PVdF) as a binder, and N-methyl-pyrrolidone were added as appropriate and stirred and mixed to prepare a slurry dispersion.

This dispersion was applied on an aluminum foil having a thickness of 20 $\mu$m using a roll coater to a uniform thickness, and after drying, the obtained sheet composed of the positive electrode composite layer and the current collector was adjusted to a positive electrode composite layer density of 3.1 to 3.2 g/cm$^3$ using a roll press, and this was punched out such that the area of the composite layer applied portion was 20.00 cm$^2$ (4.0 cm x 5.0 cm) and the composite layer unapplied portion (= tab portion) was 1.5 cm$^2$ (1.0 cm x 1.5 cm), thereby obtaining the positive electrode. This is referred to as a positive electrode sheet (sheet composed of a positive electrode composite layer and a current collector). The weight was about 7 mg/cm$^2$.

The electrode density of the positive electrode (positive electrode density) was calculated similarly to that of the negative electrode.

Calculation of A/C

The negative electrode sheet was punched out to 16 mmø and a separator (microporous film made of polypropylene) impregnated with an electrolytic solution was interposed and laminated in an insulated gasket made of polypropylene (inner diameter of about 18 mm) using the negative electrode described above and a 1.7 mm thick metallic lithium foil punched out to 17.5 mmø. At this time, the surface of the negative electrode composite layer of the negative electrode was laminated so as to face the metallic lithium foil across the separator. This was placed in a 2320-coin type cell and sealed using a rivet machine to form a lithium opposing electrode cell. For the electrolytic solution in the lithium opposing electrode cell, a liquid was used that was obtained by mixing 1 part by mass of vinylene carbonate (VC) with 100 parts by mass of solvent in which ethylene carbonate, ethyl methyl carbonate, and diethyl carbonate were mixed at a 3:5:2 volume ratio, and further dissolving electrolyte lithium hexafluorophosphate (LiPF$_6$) into such to a concentration of 1.2 mol/L. Constant current (CC) discharging was performed on the lithium opposing electrode cell at 20°C from OCV (Open Circuit Voltage) to 0.005 V at a current value equivalent to 0.1 C. This was switched to constant voltage (CV) charging at the time point when 0.005 V was reached. The cut-off condition was set as the time point at which the current value attenuated to a 0.005 C equivalent. Next, constant current charging was performed at a current value equivalent to 0.1 C as an upper limit voltage of 1.5 V. Thereafter, discharge was performed again under the above conditions, and the specific capacity at this time was multiplied by the mass of the negative electrode material in the bipolar cell to obtain a charging capacity A of the negative electrode.

A lithium opposing electrode cell was produced for the positive electrode sheet in the same manner as the negative electrode sheet, and CC charging was performed at 20°C from OCV to 4.3 V at a current value equivalent to 0.1 C. This was switched to CV charging at the time point when 4.3 V was reached. The cut-off condition was set as the time point at which the current value attenuated to a 0.005 C equivalent. Next, constant current discharging was performed at a current value equivalent to 0.1 C as a lower limit voltage of 2.5 V. Thereafter, charging was performed again under the above conditions, and the specific capacity at this time was multiplied by the mass of the positive electrode material in the bipolar cell to obtain a charging capacity C of the positive electrode.

The ratio of the charging capacity of the negative electrode to the charging capacity of the positive electrode in the bipolar cell, A/C, was 1.10.

Production of Bipolar Cell

For both the negative electrode and the positive electrode, an Al tab was attached to the Al foil, and a Ni tab was attached to the Cu foil. The electrolytic solution obtained by laminating these facing each other through a polypropylene film microporous membrane, packing them using aluminum laminate, and dissolving 1 part by mass of vinylene carbonate (VC) into 100 parts by mass of solvent in which ethylene carbonate, ethyl methyl carbonate, and diethyl carbonate were mixed at a 3:5:2 volume ratio, and further dissolving electrolyte lithium hexafluorophosphate ($LiPF_6$) into such to a concentration of 1.2 mol/L was poured and the opening was sealed by thermal fusion to produce a battery. The bipolar cell was configured having two cells for one condition, one for continuing the charge/discharge test and the other for disassembling and measuring XPS measurement partway.

[2] Charge/discharge test

A test was performed using the bipolar cell.

The cell was charged in a constant temperature vessel at 20°C at an upper limit of 4.2 V and a cutoff current value of 2.5 mA at a value equivalent to 0.2 C in the CC mode, and discharged at 0.2 C in the CC mode at a lower limit of 2.7 V. The above operation was repeated a total of four times to set the fourth discharge capacity as a reference capacity (a) of the bipolar cell.

For charging using a bipolar cell for which the reference capacity was found, CC mode charging was performed from OCV at an upper limit voltage of 4.2 V equivalent to 0.2 C.

The discharge was performed at a lower limit voltage of 2.7 V at 0.2 C in the CC mode.

This charging and discharging operation was repeated in a constant temperature vessel at 20°C as one cycle, and the discharge capacity of the nth repetition was set to the cycle discharge capacity (b). The number of cycles was found when the cycle discharge capacity (b)/reference capacity (a) of the bipolar cell measured under the above conditions was expressed as a percentage, that is, $100 \times (b)/(a)$ was the cycle capacity maintenance rate, and the retention rate was 95% or 90%.

[3] XPS Analysis

Furthermore, one of the batteries in a discharged state when the capacity maintenance rate was 95% was dismantled in a glove box in an argon atmosphere (oxygen concentration of less than 1 ppm, dew point of less than -70°C), which is an inert gas atmosphere, and the negative electrode was removed. Next, the negative electrode was washed using dimethyl carbonate and then dried by holding in a vacuum atmosphere at 25°C. After drying, the negative electrode was conveyed to an X-ray photoelectron spectroscopy system while being held in an argon atmosphere using a transfer vessel, and I528 (O1s)/I531(O1s) was calculated by performing measurement by the following method.

[Measuring Device]

Device: K-Alpha (made by Thermo Scientific) X-ray source: Al K$\alpha$ line (12 kV, 6 mA) analysis range: ø200 $\mu$m Vacuum degree before measurement: less than $5.0 \times 10^{-8}$ mBar

[Energy Compensation]

For the narrow spectrum, the LiF-derived peaks of the F1s spectrum were corrected to match 685 eV.

The results are shown in Table 1.

[Comparative Example 1]

Evaluation was carried out using the same technique as in Example 1 except that Si particles having a Dv50 of 100 nm were used instead of composite particles and when the slurry for forming the negative electrode composite layer was prepared, 5.0 parts by mass of Si particles and 91.4 parts by mass of graphite particles were used.

[Comparative Example 2]

Evaluation was carried out using the same technique as in Example 1 except that SiO particles (LixSiO) doped with Li having a Dv50 of 10 nm were used instead of composite particles and when the slurry for forming the negative electrode composite layer was prepared, 7.8 parts by mass of SiO particles and 88.6 parts by mass of graphite particles were used.

[Comparative Example 3]

Composite particles (Si/C particles) were produced without performing steps after obtaining the composite particles including porous carbon and silicon by causing $SiH_4$ to act on porous carbon in Example 1. Evaluation was carried out using the same technique as in Example 1 except that when the slurry for forming the negative electrode composite layer was prepared, 10.0 parts by mass the Si-C and 86.4 parts by mass of graphite particles were used.

[Table 1-1]

| | Raw Carbon | Step | | | | | | | Si-based negative electrode material | |
|---|---|---|---|---|---|---|---|---|---|---|
| | Carbon material | Silane gas treatment | Low temperature hydrocarbon treatment | Lithium carbonate coat | Conversion to lithium oxide | Precipitation of Si on surface | Hydrosilyation | Type | Dv50 |
| | - | - | - | - | - | - | - | - | μm |
| Example 1 | Porous carbon | Yes | Yes | Yes | Yes | Yes | Yes | Si-C | 12 |
| Comparative example 1 | No | No | No | No | No | No | No | Si | 0.1 |
| Comparative example 2 | No | No | No | No | No | No | No | LixSiO | 0.01 |
| Comparative example 3 | Porous carbon | Yes | No | No | No | No | No | Si-C | 12 |

EP 4 664 544 A1

[Table 1-2]

| | Negative electrode composite layer | | | | Negative electrode | Bipolar cell | | |
|---|---|---|---|---|---|---|---|---|
| | Si-based negative electrode material | Graphite particles | Binder | Silicon concentration in negative electrode composite layer | Half-width of peak of Si (111) surface | Number of cycles when capacity maintenance rate is 95% | I528 (Ols)/ I531 (Ols) | Number of cycles when capacity maintenance rate is 90% |
| | parts by mass | parts by mass | parts by mass | mass% | deg. | cycles | - | cycles |
| Example 1 | 10 | 86.4 | 3.6 | 5.0 | 8.0 | 751 | 0.32 | 1732 |
| Comparative example 1 | 5 | 91.4 | 3.6 | 5.0 | 0.4 | 713 | 0.01 | 978 |
| Comparative example 2 | 7.8 | 88.6 | 3.6 | 5.0 | 2.0 | 742 | 0.05 | 1053 |
| Comparative example 3 | 10 | 86.4 | 3.6 | 5.0 | 8.0 | 750 | 0.02 | 1201 |

In Example 1, I528 (O1s)/I531 (Ols) were in a predetermined range, resulting in a high capacity maintenance rate.

In Comparative Examples 1, 2, and 3, I528 (O1s)/I531 (Ols) is lower than 0.1, and the capacity maintenance rate decreases rapidly after the capacity maintenance rate falls below 95%.

## Claims

1. A negative electrode for a lithium-ion battery comprising carbon and silicon, wherein:

the negative electrode has a silicon concentration in a negative electrode composite layer of 2 mass% or more and 80 mass% or less, a half-width of a peak on a (111) plane of Si is 3.0 deg. or more in an XRD pattern of the negative electrode using Cu-K$\alpha$ lines;

a charge/discharge test is performed under the following conditions using a lithium-ion battery in which the negative electrode, a separator, and a positive electrode are laminated and an electrolytic solution in which a support lithium salt is dissolved in a carbonate ester solvent is used, and when a capacity maintenance rate of the battery is 95%; and

when, in an X-ray photoelectron spectroscopy (XPS) spectrum of a negative electrode surface, a peak height near a binding energy of 528 eV is I528 (Ols), and a peak height near 531 eV is I531 (O1s), then I528 (O1s)/I531 (O1s) $\geq$ 0.1.

Here, the conditions of the charge/discharge test are as follows.

When a charging capacity of the positive electrode of the battery is C and a charging capacity of the negative electrode is A, then A/C = 1.01 to 1.34, an upper limit voltage when charging in the charge/discharge test is 3.8 to 4.5 V; and a lower limit voltage is 3.0 to 2.5 V.

2. The negative electrode for a lithium-ion battery of claim 1, comprising composite particles comprising a carbon material and silicon as a negative electrode material constituting the negative electrode.

3. The negative electrode for a lithium-ion battery of claim 1, wherein a positive electrode material in the positive electrode of the battery used in the charge/discharge test comprises at least one type selected from $Li_xNi_aMn_{b-}Co_cAl_dO_y$ ($0 < x \leq 1.1, 2 \leq y \leq 2.02, 0 \leq a \leq 1, 0 \leq b \leq 1, 0 \leq c \leq 1, 0 \leq d < 1, 0 < a + b + c + d \leq 1$), and $Li_zM_mPO_4$ ($0 \leq z \leq 1.1, 0.8 \leq m \leq 1.2$, and M is one or more type selected from Fe, Mn, Co, and Ni).

4. The negative electrode for a lithium-ion battery of claim 1, wherein a temperature during aging in the charge/discharge test is 45°C and a current value is equivalent to 0.1 C.

5. The negative electrode for a lithium-ion battery of claim 1, wherein a temperature during capacity confirmation in the charge/discharge test is 20°C and a current value is equivalent to 0.2 C.

6. The negative electrode for a lithium-ion battery of claim 1, wherein a temperature during a charge/discharge cycle in the charge/discharge test is 20°C and a current value is 0.2 C.

7. A lithium-ion battery comprising the negative electrode for a lithium-ion battery of claim 1, an electrolyte, and a positive electrode.

8. A method for manufacturing a negative electrode material for a lithium-ion battery, comprising:

   a step for manufacturing composite particles including a carbon material and silicon by precipitating an Si-containing compound in pores of or on a surface and in the pores of the carbon material; and
   a step for causing a carbon source having an unsaturated bond to act on the composite particles at a lower temperature than that step.

9. The method for manufacturing a negative electrode material for a lithium-ion battery of claim 8, further comprising:

   a step for attaching a lithium salt to a composite particle surface on which the carbon source having an unsaturated bond has been caused to act;
   a step for converting the lithium salt to lithium oxide by heating in the presence of hydrogen; and
   a step for further attaching an Si-containing compound and hydrosilylizing the composite particle surface by causing an unsaturated hydrocarbon to act.

10. The method for manufacturing the negative electrode material for a lithium-ion battery of claim 9, wherein the lithium salt is lithium carbonate.

11. A method for manufacturing a negative electrode material for a lithium-ion battery, comprising:

    a step for obtaining composite particles including a carbon material and silicon by precipitating an Si-containing compound in pores of or on a surface and in the pores of the carbon material;
    a step for attaching lithium alkoxide to a composite particle surface; and
    a step for attaching an Si-containing compound and hydrosilylizing the composite particle surface by causing an unsaturated hydrocarbon to act.

12. A method for distinguishing a negative electrode having favorable cycle characteristics, wherein:

    a charge/discharge test is performed using a lithium-ion battery in which a negative electrode, a separator, and a positive electrode are laminated and an electrolytic solution in which a support lithium salt is dissolved in a carbonate ester solvent is used, and when a capacity maintenance rate of the battery is 95%; and
    when, in an X-ray photoelectron spectroscopy (XPS) spectrum of a surface, a peak height near a binding energy of 528 eV is I528 (Ols), and a peak height near 531 eV is I531 (Ols), then a value of I528 (O1s)/I531 (Ols) is used. Here, the conditions of the charge/discharge test are as follows.
    When a charging capacity of the positive electrode of the battery is C and a charging capacity of the negative electrode is A, then A/C = 1.01 to 1.34, an upper limit voltage when charging in the charge/discharge test is 3.8 to 4.5 V, and a lower limit voltage is 3.0 to 2.5 V.

13. The method for distinguishing of claim 12, wherein the composite particles comprise a carbon material and silicon as a negative electrode material constituting the negative electrode.

14. The method for distinguishing of claim 12, wherein a positive electrode material in the positive electrode of the battery used in the charge/discharge test comprises at least one type selected from $Li_xNi_aMn_bCo_cAl_dO_y$ ($0 < x \leq 1.1$, $2 \leq y \leq 2.02$, $0 \leq a \leq 1$, $0 \leq b \leq 1$, $0 \leq c \leq 1$, $0 \leq d < 1$, $0 < a + b + c + d \leq 1$), and $Li_zM_mPO_4$ ($0 \leq z < 1.1$, $0.8 \leq m \leq 1.2$, and M is one or more type selected from Fe, Mn, Co, and Ni).

15. The method for distinguishing of claim 12, wherein a temperature during aging in the charge/discharge test is 45°C and a current value is equivalent to 0.1 C.

16. The method for distinguishing of claim 12, wherein a temperature during capacity confirmation in the charge/-discharge test is 20°C and a current value is equivalent to 0.2 C.

17. The method for distinguishing of claim 12, wherein a temperature during a charge/discharge cycle in the charge/-discharge test is 20°C and a current value is 0.2 C.

## INTERNATIONAL SEARCH REPORT

| International application No. |
|---|
| **PCT/JP2023/041033** |

**A. CLASSIFICATION OF SUBJECT MATTER**

*H01M 4/133*(2010.01)i; *H01M 4/134*(2010.01)i; *H01M 4/1393*(2010.01)i; *H01M 4/1395*(2010.01)i; *H01M 4/36*(2006.01)i; *H01M 4/38*(2006.01)i; *H01M 4/587*(2010.01)i

FI:  H01M4/133; H01M4/134; H01M4/1393; H01M4/1395; H01M4/36 A; H01M4/36 E; H01M4/38 Z; H01M4/587

According to International Patent Classification (IPC) or to both national classification and IPC

**B. FIELDS SEARCHED**

Minimum documentation searched (classification system followed by classification symbols)

H01M4/133; H01M4/134; H01M4/1393; H01M4/1395; H01M4/36; H01M4/38; H01M4/587

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2022/270539 A1 (SHOWA DENKO K.K.) 29 December 2022 (2022-12-29) paragraphs [0164]-[0168], [0200] | 8 |
| A | | 1-7, 9-17 |
| A | JP 2018-534720 A (ENERG2 TECHNOLOGIES, INC.) 22 November 2018 (2018-11-22) | 1-17 |
| A | WO 2021/241751 A1 (SHOWA DENKO K.K.) 02 December 2021 (2021-12-02) | 1-17 |
| A | WO 2023/008093 A1 (SHIN-ETSU CHEMICAL CO., LTD.) 02 February 2023 (2023-02-02) | 1-17 |

☐ Further documents are listed in the continuation of Box C.     ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **25 January 2024** | **06 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2023/041033**

| Patent document cited in search report | | | Publication date (day/month/year) | Patent family member(s) | | | Publication date (day/month/year) |
|---|---|---|---|---|---|---|---|
| WO | 2022/270539 | A1 | 29 December 2022 | (Family: none) | | | |
| JP | 2018-534720 | A | 22 November 2018 | JP | 2022-153561 | A | |
| | | | | US | 2017/0170477 | A1 | |
| | | | | US | 2019/0280298 | A1 | |
| | | | | US | 2020/0075954 | A1 | |
| | | | | US | 2020/0365896 | A1 | |
| | | | | US | 2020/0152983 | A1 | |
| | | | | US | 2022/0231296 | A1 | |
| | | | | US | 2022/0352517 | A1 | |
| | | | | US | 2023/0058348 | A1 | |
| | | | | WO | 2017/040299 | A1 | |
| | | | | EP | 3836261 | A1 | |
| | | | | CN | 108475779 | A | |
| | | | | KR | 10-2018-0113187 | A | |
| | | | | CN | 113224274 | A | |
| | | | | KR | 10-2023-0091915 | A | |
| | | | | KR | 10-2023-0092015 | A | |
| WO | 2021/241751 | A1 | 02 December 2021 | US | 2023/0234852 | A1 | |
| | | | | EP | 4159675 | A1 | |
| | | | | CN | 115699360 | A | |
| | | | | KR | 10-2023-0017260 | A | |
| WO | 2023/008093 | A1 | 02 February 2023 | JP | 2023-18574 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017168466 A
- JP 2013232413 A
- US 10424786 B
- JP 5950160 B